# EUROPEAN PATENT SPECIFICATION

(11) **EP 4 148 418 B1**
(45) Date of publication and mention of the grant of the patent: **07.10.2026**
(21) Application number: 21825303.7
(22) Date of filing: 04.05.2021
(51) Int. Cl.: G01N 21/65, H10P 14/20, B82Y 40/00, H10P 14/26

(54) **NANOSTRUCTURE-BASED SUBSTRATE FOR SURFACE-ENHANCED RAMAN SPECTROSCOPY, AND MANUFACTURING METHOD THEREFOR**
SUBSTRAT AUF NANOSTRUKTURBASIS FÜR OBERFLÄCHENVERSTÄRKTE RAMAN-SPEKTROSKOPIE UND HERSTELLUNGSVERFAHREN DAFÜR
SUBSTRAT À BASE DE NANOSTRUCTURE POUR SPECTROSCOPIE D'EFFET RAMAN EXALTÉ DE SURFACE, ET SON PROCÉDÉ DE FABRICATION

(30) Priority: 16.06.2020 KR 20200073275
(43) Date of publication of application: 15.03.2023
(73) Proprietor: The Asan Foundation, Seoul 05505 (KR); University Of Ulsan Foundation For Industry Cooperation, Ulsan 44610 (KR)
(72) Inventor: KIM, Jun Ki, Seoul 05108 (KR); LEE, Sang Hwa, Seoul 08804 (KR)
(74) Representative: dompatent
(86) International application number: PCT/KR2021/005586
(87) International publication number: WO 2021/256701

(56) References cited:
- CN-A- 110 568 192
- JP-A- 2005 519 187
- JP-A- 2019 020 406
- JP-A- 2019 117 140
- KR-A- 20020 074 163
- KR-A- 20130 094 505
- KR-B1- 101 256 757
- KR-B1- 101 272 502
- US-A1- 2013 109 030
- SANGHWA LEE ET AL: "Surface-Enhanced Raman Spectroscopy (SERS) based on ZnO nanorods for biological applications", 4 February 2019, ZINC OXIDE BASED NANO MATERIALS AND DEVICES, INTECH OPEN, PAGE(S) 1 - 13, ISBN: 978-1-78923-957-7, XP009533173
- LI XIAO ET AL: "An electrochemical microfluidic paper-based glucose sensor integrating zinc oxide nanowires", 2015 28TH IEEE INTERNATIONAL CONFERENCE ON MICRO ELECTRO MECHANICAL SYSTEMS (MEMS), IEEE, 18 January 2015 (2015-01-18), pages 447 - 450, XP032741106, DOI: 10.1109/MEMSYS.2015.7050986
- HAIBIN TANG ET AL: "Arrays of Cone-Shaped ZnO Nanorods Decorated with Ag Nanoparticles as 3D Surface-Enhanced Raman Scattering Substrates for Rapid Detection of Trace Polychlorinated Biphenyls", ADVANCED FUNCTIONAL MATERIALS, WILEY - V C H VERLAG GMBH & CO. KGAA, DE, vol. 22, no. 1, 2 December 2011 (2011-12-02), pages 218 - 224, XP072292898, ISSN: 1616-301X, DOI: 10.1002/ADFM.201102274
- JUN ZHAO ET AL: "Significantly enhanced UV luminescence by plasmonic metal on ZnO nanorods patterned by screen-printing", NANOTECHNOLOGY, INSTITUTE OF PHYSICS PUBLISHING, BRISTOL, GB, vol. 29, no. 35, 25 June 2018 (2018-06-25), pages 355703, XP020329755, ISSN: 0957-4484, [retrieved on 20180625], DOI: 10.1088/1361-6528/AACB52
- SANGHWA LEE, JUN KI KIM: "Surface-Enhanced Raman Spectroscopy (SERS) based on ZnO nanorods for biological applications.", ZINC OXIDE BASED NANO MATERIALS AND DEVICES., 4 February 2019 (2019-02-04), pages 1 - 13, XP009533173, ISBN: 978-1-78923-957-7, DOI: 10.5772/intechopen.84265

## Description

### [TECHNICAL FIELD]

The present invention relates to a method for manufacturing a nanostructure-based substrate for surface-enhanced Raman spectroscopy and to a nanostructure-based substrate for surface-enhanced Raman spectroscopy manufactured by the method.

### [BACKGROUND ART]

Surface-enhanced Raman spectroscopy, which is a non-destructive analysis, is a technology of identifying chemical components through spectra for molecular-specific vibration energy modes without the influence of ambient moisture.

According to the Surface-enhanced Raman spectroscopy, the detection of a single molecule signal may be maximized, and minimize the interference between markers without the influence by the distinction, thereby enabling high-sensitivity analysis with accuracy of the test.

SANGHWA LEE ET AL: "Surface-Enhanced Raman Spectroscopy (SERS) based on ZnO nanorods for biological applications", 4 February 2019, ZINC OXIDE BASED NANO MATERIALS AND DEVICES, INTECH OPEN, pages 1 - 13, describes a method for manufacturing a nanostructure-based substrate for surface-enhanced Raman spectroscopy, wherein a ZnO seed layer is deposited on a Si wafer surface by using RF magnetron sputtering to grow the vertically aligned ZnO nanorods utilizing by the hydrothermal synthesis. The ZnO growth solution was prepared by dissolving zinc nitrate hexahydrate and ammonium hydroxide in 30 mL DI water. A homogeneous aqueous solution was achieved using mildly stirred vortexer for 5 min at room temperature. Then, the as-prepared samples were immersed into the aqueous solution in an oven at 90°C for 50 min. After ZnO growth, the substrates were cleaned with DI water and dried with nitrogen gas. Finally, the ZnO nanorods (NRs) were coated with Au using a thermal evaporator.

HAIBIN TANG ET AL: "Arrays of Cone-Shaped ZnO Nanorods Decorated with Ag Nanoparticles as 3D Surface-Enhanced Raman Scattering Substrates for Rapid Detection of Trace Polychlorinated Biphenyls", ADVANCED FUNCTIONAL MATERIALS, WILEY - V C H VERLAG GMBH & CO. KGAA, DE, vol. 22, no. 1, 2 December 2011, pages 218-224 and JUN ZHAO ET AL: "Significantly enhanced UV luminescence by plasmonic metal on ZnO nanorods patterned by screen-printing", NANOTECHNOLOGY, INSTITUTE OF PHYSICS PUBLISHING, BRISTOL, GB, vol. 29, no. 35, 25 June 2018 (2018-06-25), pages 1-9, also describe methods for manufacturing a nanostructure-based substrate for surface-enhanced Raman spectroscopy using ZnO seed layers.

Accordingly, the Surface-enhanced Raman spectroscopy has recently been used for analysis in various fields, such as the diagnosis of targets controlled by antigen-antibody, medical bio, agriculture, and environment. Accordingly, the Surface-enhanced Raman spectroscopy is highly applicable to a next-generation high-sensitivity diagnosis and analysis device.

However, the conventional nanoparticle surface-enhanced technology has a limitation in that only antigen-antibody controlled targets are diagnosed. A nanowire-based substrate for surface enhancement has the form in which a nanowire is laid down and spread on a substrate to make many pores, such that the substrate becomes weak.

In addition, a pattern or an etched part based on a top-down scheme through a conventional lithography process has a limitation in size. Accordingly, a region for forming a hot spot may be reduced.

### [DETAILED DESCRIPTION OF THE INVENTION]

### [TECHINICAL PROBLEM]

Embodiments of the inventive concept provide a surface-enhanced Raman spectroscopy substrate capable of accurately diagnosing markers having various sizes and various types in a sample.

In addition, embodiments of the inventive concept provide a surface-enhanced Raman spectroscopy substrate, in which even a large number of samples can be rapidly analyzed and diagnosed.

The objects of the inventive concept are not limited to the above, but other effects, which are not mentioned, will be apparently understood to those skilled in the art.

### [TECHNICAL SOLUTION]

According to invention, a method for manufacturing a nanostructure-based substrate for surface-enhanced Raman spectroscopy as defined in appended independent claim 1 is provided.

According to the invention, a nanostructure-based substrate for surface-enhanced Raman spectroscopy as defined in appended independent claim 8 is provided. Particular embodiments of the invention are defined in the appended dependent claims.

Embodiments of the invention are included in the detailed description and drawings.

### [ADVANTAGEOUS EFFECTS OF THE INVENTION]

According to the present invention, defined by the claims, a nanostructure-based substrate for surface-enhanced Raman spectroscopy and a method for manufacturing the same have following effects.

First, a specific nanometer marker in a liquid sample is selectively measured, and the surface enhancement effect on the marker is maximized.

Second, a diffusion direction of a sample drop is controlled by utilizing a substrate which is patterned, such that a position for acquiring a Raman signal may be easily detected inside the surface-enhanced Raman spectroscopy substrate.

Third, lower-temperature growth may be performed. Accordingly, the nanostructure may be grown without deforming the flexible substrate allowing pattern printing.

Fourth, marks having various sizes may be analyzed through one sample drop.

The effects of the inventive concept are not limited to the above, but other effects, which are not mentioned, will be apparently understood to those skilled in the art.

### [DESCRIPTION OF THE DRAWINGS]

FIG. 1 is a flowchart illustrating a method for manufacturing a nanostructure-based substrate for surface-enhanced Raman spectroscopy, according to an embodiment of the inventive concept;
FIGS. 2A to 2C are views illustrating a method for manufacturing a nanostructure-based substrate for surface-enhanced Raman spectroscopy, according to the inventive concept;
FIGS. 3A to 3C are views illustrating the forms of nanostructures grown under different conditions, when manufacturing a nanostructure-based substrate for surface-enhanced Raman spectroscopy;
FIGS. 4A and 4B are views illustrating nanostructures grown to have different forms in the unit of an array inside a substrate;
FIGS. 5A and 5B are views illustrating the diffusion degree of a sample inside a substrate having a specific pattern;
FIG. 6 is a flowchart illustrating a method for manufacturing a multi-sample measurement chip by combining at least two surface-enhanced Raman spectroscopy substrates;
FIG. 7 is a view illustrating the configuration of a multi-sample measurement chip including surface-enhanced Raman spectroscopy substrates and sample inlets;
FIG. 8 is a view illustrating a method for moving a sample from a sample inlet to a surface-enhanced Raman spectroscopy substrate; and
FIG. 9 is a view illustrating a surface-enhanced Raman spectroscopy substrate, according to the inventive concept.

### [BEST MODE]

The above and other aspects, features and advantages of the inventive concept will become apparent from embodiments to be described in detail in conjunction with the accompanying drawings. Within the scope defined by the appended claims, the inventive concept, however, may be embodied in various different forms, and should not be construed as being limited only to the illustrated embodiments. Rather, these embodiments are provided as examples so that the inventive concept will be thorough and complete, and will fully convey the scope of the inventive concept to those skilled in the art. The inventive concept is defined by the scope of the claims.

The terms used herein are provided to describe embodiments, not intended to limit the inventive concept. In the specification, the singular forms include plural forms unless particularly mentioned. The terms "comprises" and/or "comprising" used herein do not exclude the presence or addition of one or more other components, in addition to the aforementioned components. The same reference numerals denote the same components throughout the specification. As used herein, the term "and/or" includes each of the associated components and all combinations of one or more of the associated components. It will be understood that, although the terms "first", "second", etc., may be used herein to describe various components, these components should not be limited by these terms. These terms are only used to distinguish one component from another component. Accordingly, a first component that is discussed below could be termed a second component without departing from the technical idea of the inventive concept.

Unless otherwise defined, all terms (including technical and scientific terms) used herein have the same meaning as commonly understood by those skilled in the art to which the inventive concept pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the present specification, the term "substrate" refers to a substrate basically formed to grow a nanostructure.

In the present specification, the term "substrate (or surface-enhanced Raman spectroscopy substrate) for surface-enhanced Raman spectroscopy" refers to one array having a nanostructure grown thereon, capable of recognizing a Raman signal enhanced, when the nanostructure is grown on the substrate, metal coating is performed, and a sample is injected.

In the present specification, the term "multi-sample measurement chip" refers to a measurement chip including a plurality of arrays formed, as a plurality of surface-enhanced Raman spectroscopy substrates are combined with each other.

In the present specification, the term "nanostructure" refers to a nanostructure having the diameter in nanosize, and may include a nanowire, a naotube, or a nanorod.

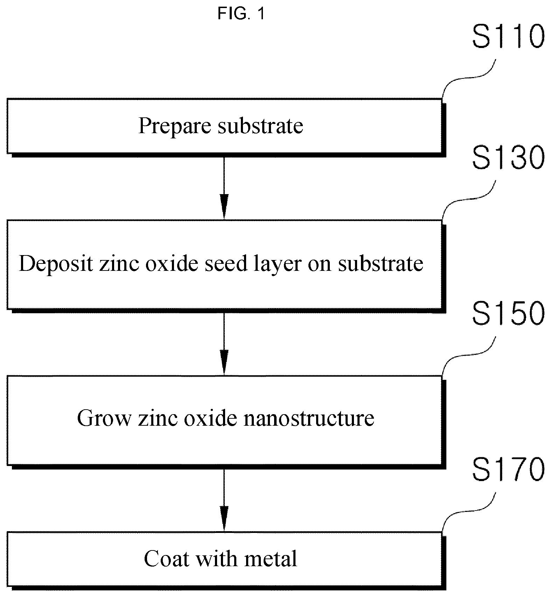

FIG. 1 is a flowchart illustrating a method for manufacturing a nanostructure-based substrate for surface-enhanced Raman spectroscopy, according to an embodiment of the inventive concept.

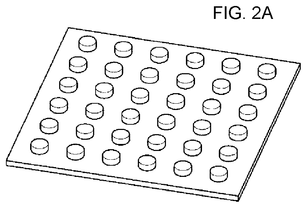

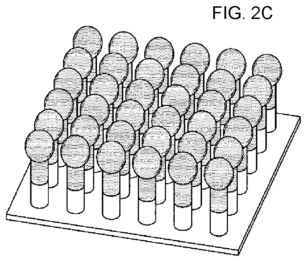

FIGS. 2A to 2C are views illustrating a method for manufacturing a nanostructure-based substrate for surface-enhanced Raman spectroscopy, according to an embodiment of the inventive concept.

Referring to FIG. 1, the method for manufacturing the nanostructure-based substrate for surface-enhanced Raman spectroscopy includes preparing a substrate (S110), depositing a zinc oxide (ZnO) seed layer (S130), growing a zinc oxide nanostructure (S150), and coating with a metal (S170).

Raman analysis is a useful measurement technique in detecting chemical species of a sample. Surface-enhanced Raman spectroscopy (SERS) is an analysis technique of using a rapid increase in Raman signal strength of molecules adsorbed on a rough metal surface or nanostructure surface, and of making it easy to measure a low concentration of samples by overcoming the low detection sensitivity of a conventional Raman manner technique.

In addition, the most important part of the SERS is a substrate in a metal nanostructure, which has a feature that the degree of amplification of the Raman signal is significantly varied depending on the shape and structure of the substrate.

The inventive concept proposes a method for the shape and structure of the substrate differently produced depending on the characteristics of a specific measurement sample. According to the inventive concept, a feature capable of amplifying a signal of a biomarker to be measured in a measurement sample is DT.

In the step of preparing the substrate (S110), the substrate includes at least one of silicon, glass, PET, and an OHP film.

In general, to form the surface-enhanced Raman spectroscopy substrate, a nanostructure should be grown at a higher temperature. Various manners are employed to grow the nanostructure, and the nanostructure is grown in the range of a lower temperature of 150°C to a higher temperature of 600°C. In this case, since the higher growth temperature is provided, a substrate, which is not deformed even in the range of 150°C to 600°C, should be used.

However although a substrate according to the inventive concept is not appropriate to use at a higher temperature, the substrate may be employed according to the inventive concept, because a nanostructure is grown at a lower temperature (for example, approximately 80°C etc.) in which the substrate is not deformed according to the inventive concept. A zinc oxide nanostructure may be grown at a lower temperature. Accordingly, the zinc oxide nanostructure is employed for low temperature growth according to the inventive concept. Hereinafter, a manner for utilizing the substrate to manufacture the surface-enhanced Raman spectroscopy substrate of the inventive concept will be described in detail.

When the step of depositing a zinc oxide (ZnO) seed layer on the substrate is performed (S130), it may be recognized that the seed layer is deposited on the substrate as illustrated in FIG. 2A.

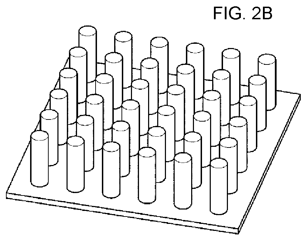

Thereafter, when the step of growing the zinc oxide nanostructure (S150) is performed, it may be recognized that the nanostructure is grown on the substrate as illustrated in FIG. 2B.

The step of growing the zinc oxide nanostructure (S150) is to grow the zinc oxide nanostructure through a synthesis manner of applying a zinc (Zn) solution to the seed layer. The synthesis manner of applying the zinc (Zn) solution may be performed through a hydrothermal synthesis manner or the like.

According to the invention as claimed, the step of growing the zinc oxide nanostructure (S150) is to adjust at least one of the spacing between nanostructures and the growing direction of the nanostructure by using at least one of a temperature adjusting manner and a zinc-based solution surface treatment manner, depending on the characteristic of a sample to be measured.

The inventive concept is to manufacture a substrate for measuring a solution sample, and mainly includes obtaining information from a biometric sample. The biometric sample, which is a solution sample measured on the substrate according to the inventive concept, includes all forms, such as tears, blood, urine, feces, sweat, and saliva, which contribute to the byproducts and metabolism of a living creature, and may provide a basis for diagnosis by measuring a biomarker and a reagent treatment result present in the biometric sample. The biomarker includes a cell (in several tens *µ*m, a red blood cell (in 8 *µ*m), bacteria (in 1 *µ*m), exosomes (in the range of several nm to several tens nm), and proteins, according to sizes.

Accordingly, the nanostructure-based substrate for surface-enhanced Raman spectroscopy having nanometer spacing according to the inventive concept may be used to measure a nano-sized biomaterial, such as a protein, a lipid, a nucleic acid, an exosome, and a metabolic substance.

Bio-particles may have a hot spot in the spacing between nanostructures and the structure of the nanostructure on the surface-enhanced Raman spectroscopy substrate, depending on the characteristic of the bio-particles, which include the size of the bio-particles. Accordingly, the bio-particles should be measured by manufacturing the surface-enhanced Raman spectroscopy substrate, based on the characteristic of the bio-particles to be measured.

According to an embodiment, when the nanostructure is grown by adjusting a temperature, the spacing between the nanostructures grown by adjusting the temperature is adjusted. As described above, the nanostructure may be grown, as the spacing of the nanostructures is adjusted by adjusting the temperature, in match with the spacing of particles to be enhanced in the solution sample to be measured.

In this case, although the nanostructure is produced depending on the position of the deposited seed layer, the thickness of the nanostructure is adjusted by adjusting the temperature, thereby adjusting the spacing between the nanostructures.

According to an embodiment, when the zinc-based solution surface treatment is used in growing the nanostructure, the growing direction of the nanostructure is adjusted.

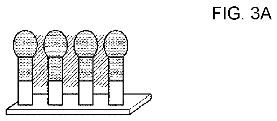

FIGS. 3A to 3C are views illustrating the forms of nanostructures grown under different conditions, when manufacturing a nanostructure-based substrate for surface-enhanced Raman spectroscopy.

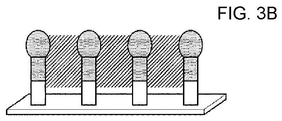

FIGS. 3A and 3B are views illustrating a nanostructure grown, as the spacing between nanostructures is adjusted by adjusting the temperature when growing the nanostructure. FIGS. 3A and 3B are views illustrating nanostructures grown at mutually different temperatures.

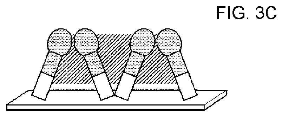

FIG. 3C is a view illustrating a nanostructure grown by adjusting the growing direction of the nanostructure through zinc-based solution surface treatment, when growing the nanostructure, Referring to FIG. 3C, it may be recognized that the nanostructure may be grown while being titled in various directions by adjusting the growing direction of the nanostructure.

In addition, according to an embodiment, the nanostructures may be grown to be different in at least one of the spacing between the nanostructures and the growing direction of the nanostructure inside one substrate.

The wording "the nanostructures grown to be different in one substrate" refers to that the nanostructure is grown to be different in the unit of an array. In addition, the wording "the nanostructures grown to be different in one substrate" refers to including that nanostructures are grown at equal spacing and in the same direction in the unit of a row and/or column, that nanostructures are grown to be different in the unit of a row, or in the unit of a column inside the substrate, or that the nanostructures are grown to be different in at least one of spacing or the growing direction, in the same row or the same row.

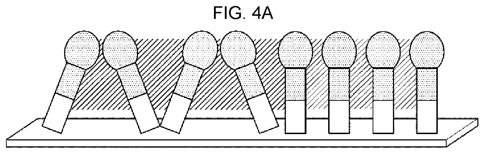

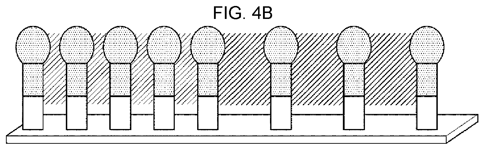

FIGS. 4A and 4B are views illustrating nanostructures grown to have different forms in the unit of an array inside a substrate.

Referring to FIGS. 4A and 4B, it may be recognized that nanostructures are formed to have different forms even in the unit of an array, as described above. Referring to FIG. 4A, the left part are grown by adjusting the growing direction of the nanostructures, and the right part are uniformly grown at a specific temperature while maintaining the growing direction to be in a vertical direction. Referring to FIG. 4B, the nanostructures at the left part and the nanostructures at the right part are grown at different temperatures while maintaining the growing direction thereof to be in the vertical direction. In this case, it may be recognized that the nanostructures have different spacings therebetween as the nanostructures are grown at the different temperatures.

As described above, a surface-enhanced Raman spectroscopy substrate is formed to be optimized for a specific sample, thereby maximizing a surface enhancement effect for a marker having a target size.

Meanwhile, the step of coating with a metal (S170) is to coat a nanostructure, which is grown in the step of growing the nanostructure (S150), with a metal

In this case, the metal may include any one of Ag, Al, Au, Co, Cu, Fe, Li, Ni, Pd, Pt, Rh, Ru, and the alloy thereof.

The process of coating the nanostructure with the metal may employ a sputtering manner, an evaporation manner, or a solution synthesis manner. According to the process of coating the nanostructure with the metal, when measuring a sample, a Raman signal strength of molecules adsorbed on the surface of the metal or the surface of the nanostructure may be rapidly increased, which makes it easy to measure a lower concentration of sample.

When a nano-sized gap between metal grains produced through the metal coating process is formed, as a hot spot region, in which a Raman signal is rapidly increased, is generated. Accordingly, the sample may be measured based on the relevant signal.

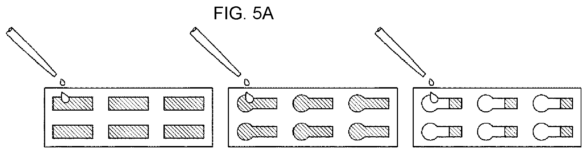

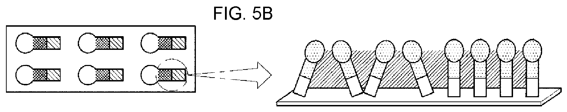

FIGS. 5A and 5B are views illustrating the diffusion degree of a sample inside a substrate having a specific pattern.

Although not additionally illustrated, the method for manufacturing the nanostructure-based substrate for surface-enhanced Raman spectroscopy

in accordance with the claimed invention further includes the step of performing a selective etching process after performing a lithography process for the substrate by utilizing a polymer film having a specific pattern printed thereon as a mask, after the step of preparing the substrate (S110) and before the step of depositing the zinc oxide seed layer on the substrate (S130). In this case, the step of depositing the zinc oxide seed layer on the substrate (S130) is to deposit a zinc oxide seed layer on the etched region.

According to another embodiment, in the step of preparing the substrate (S110) in the method for manufacturing the nanostructure-based substrate for surface-enhanced Raman spectroscopy, the substrate is a printing film. In addition, the step of preparing the substrate (S110) is to form a specific pattern by printing at least one of wax and a hydrophobic material on the substrate.

Each of FIGS. 5A and 5B illustrates the surface-enhanced Raman spectroscopy substrate, and it may be recognized that a boundary part of a region for injecting a sample is printed with a pattern. As illustrated in FIGS. 5A and 5B, the printed part may guide the sample such that the sample is prevented from crossing over the boundary line when the sample is injected, and furthermore, may control the diffusion direction of the sample.

FIGS. 5A and 5B are views illustrating a structure in which a sample is diffused when dropped in each sample measurement chip. In particular, it may be recognized from FIG. 5B that the diffusion structure of the sample is varied by a nanostructure grown by changing a condition inside one array.

In other words, the pattern is formed to control the diffusion direction of a liquid sample from a sample inlet to an inner part of a surface-enhanced Raman spectroscopy substrate. As FIGS. 5A and 5B illustrate that a liquid sample is dropped right on the surface-enhanced Raman spectroscopy substrate, it may be understood that only the diffusion direction of the liquid sample inside the surface-enhanced Raman spectroscopy substrate is controlled. However, the pattern is formed to control the direction in which the liquid sample reaches from the sample inlet to the surface-enhanced Raman spectroscopy substrate, and the diffusion direction of the liquid sample inside the surface-enhanced Raman spectroscopy substrate.

When the diffusion direction of the liquid sample is controlled through the pattern, the liquid sample may easily reach the position at which the Raman signal is acquired.

A printing-based pattern may be easily formed with respect to a polymer film including a flexible material such as PET or an OHP film described above. Accordingly, it is preferred that the polymer film is utilized to form the printing-based pattern. However, the flexible substrate is weak in heat resistance. Accordingly, the substrate may be deformed in the typical temperature range of 150°C to 500°C for growing nanostructure. Accordingly, according to the inventive concept, a flexible substrate is manufactured based on a zinc oxide nanostructure which is able to be grown based on a liquid at a lower temperature at which the flexible substrate is not deformed.

In other words, according to the inventive concept, as the zinc oxide nanostructure, which is able to be grown at a lower temperature, is introduced as a basic structure, the flexible substrate easily printed may be utilized. The utilizing of the flexible substrate makes the sample easily reach the position for acquiring the Raman signal. Accordingly, the Raman signal may be exactly acquired with respect to the size and the characteristic of a marker to be acquired from a specific sample.

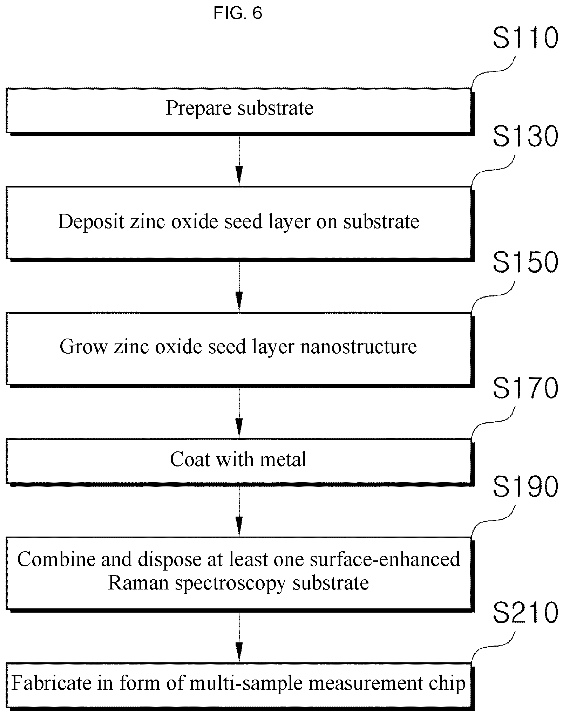

In addition, a plurality of arrays may be merged into one as illustrated in FIGS. 5A and 5B. The details thereof will be described in detail with reference to FIG. 6.

FIG. 6 is a flowchart illustrating a method for manufacturing a multi-sample measurement chip by combining at least two surface-enhanced Raman spectroscopy substrates.

Referring to FIG. 6, according to an embodiment, the method for manufacturing the multi-sample measurement chip by combining at least two surface-enhanced Raman spectroscopy substrates may further include the steps of combining and disposing at least two surface-enhanced Raman spectroscopy substrates (S190) and manufacturing in form of a multi-sample measurement chip (S210) after the method (S110 to S170) as illustrated in FIG. 1.

In the step of combining and disposing at least two surface-enhanced Raman spectroscopy substrates (S190), at least one surface-enhanced Raman spectroscopy substrate manufactured through the method to the step of coating with metal is combined and disposed. At least two surface-enhanced Raman spectroscopy substrate may be combined by considering the number of substrates required for efficiency and a test. For example, as illustrated in FIGS. 5A and 5B, six surface-enhanced Raman spectroscopy substrates may be combined and disposed. In this case, the at least one surface-enhanced Raman spectroscopy substrate combined may have pores in mutually different sizes.

As described above, when the surface-enhanced Raman spectroscopy substrates having pores in mutually different sizes are combined, nanobiomarkers having various sizes may be analyzed by dropping a sample once.

In addition, the time for Raman measurement may be reduced and a measuring point may be ensured and set within a shorter period of time, due to at least one surface-enhanced Raman spectroscopy substrate having patterns in mutually different shapes

In the step of manufacturing in form of a multi-sample measurement chip (S210), a sample inlet of each surface-enhanced Raman spectroscopy substrate is at a preset distance or more from the substrate, is formed to be in a preset size or more, and is disposed, such that the multi-sample measurement chip is formed.

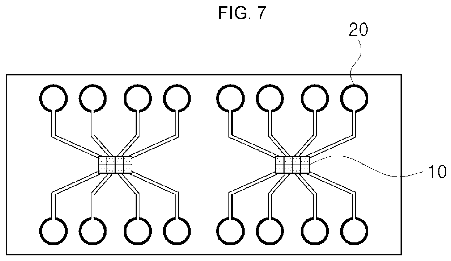

FIG. 7 is a view illustrating the configuration of a multi-sample measurement chip including surface-enhanced Raman spectroscopy substrates and sample inlets.

A sample is injected through a sample inlet 20, which is separately disposed as described above and has a specific size or more, instead of being directly injected. This is because a surface-enhanced Raman spectroscopy substrate 10 to measure the sample is reduced in size, as the surface-enhanced Raman spectroscopy substrate 10 mainly uses a smaller amount of sample, such as tear, blood, and urine. When the size of the surface-enhanced Raman spectroscopy substrate 10 is significantly reduced, care should be taken to prevent the sample from being incorrectly injected, when injecting the sample. However, according to the inventive concept, when the sample inlet 20 is separately formed to be in a specific size or more, the sample may be more easily injected.

In addition, when the surface-enhanced Raman spectroscopy substrate 10 in a smaller size is individually manufactured one by one, the surface-enhanced Raman spectroscopy substrate may be missed or lost. Accordingly, the at least one surface-enhanced Raman spectroscopy substrate 10 is combined, and the whole size of the multi-sample measurement chip is not small, such that the surface-enhanced Raman spectroscopy substrate is prevented from being missed or lost.

In this case, for the multi-sample measurement chip, samples need to be more delicately injected in the surface-enhanced Raman spectroscopy substrates 10, respectively. Accordingly, separate sample inlets 20 spaced apart from the surface-enhanced Raman spectroscopy substrate 10 by a specific distance or more and having a specific size or more may be more usefully used.

In other words, according to the inventive concept, the multi-sample measurement chip is manufactured such that the surface-enhanced Raman spectroscopy substrates 10 are densely provided and the sample inlets 20 are more widely distributed to easily supply samples.

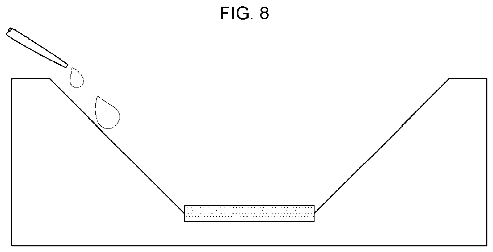

FIG. 8 is a view illustrating a method for moving a sample from the sample inlet to the surface-enhanced Raman spectroscopy substrate.

As illustrated in FIG. 7, when the surface-enhanced Raman spectroscopy substrate 10 is at a specific distance from the sample inlet 20, and when the liquid sample reaches the surface-enhanced Raman spectroscopy substrate 10 from the sample inlet 20, the liquid sample may be measured through the surface-enhanced Raman spectroscopy substrate 10.

In the manner for moving the liquid sample from the sample inlet 20 to the surface-enhanced Raman spectroscopy substrate 10 in the multi-sample measurement chip, a preset slope is formed from the sample inlet 20 to the surface-enhanced Raman spectroscopy substrate 10 as illustrated in FIG. 8. Accordingly, the liquid sample moves along the slope or moves through the injection of a syringe or a syringe pump.

In addition to the method for moving the liquid sample, various manners may be provided to allow the liquid sample to reach the surface-enhanced Raman spectroscopy substrate 10 from the sample inlet 20.

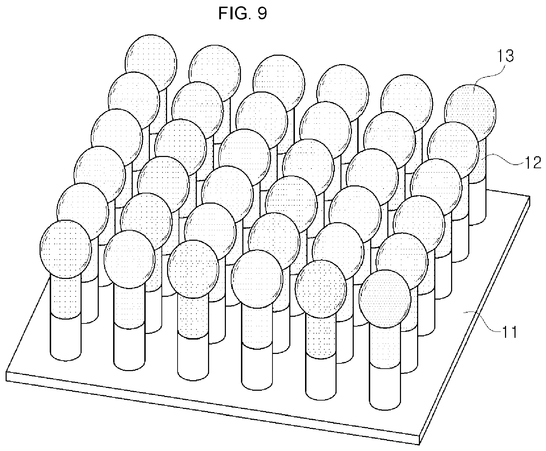

FIG. 9 is a view illustrating a surface-enhanced Raman spectroscopy substrate, according to an embodiment of the inventive concept.

Referring to FIG. 9, the surface-enhanced Raman spectroscopy substrate according to an embodiment of the inventive concept includes a substrate 11, a zinc oxide nanostructure 12 grown on the substrate, and a metal 13 coated on the nanostructure.

According to the claimed invention, the nanostructure is grown by adjusting at least one of the spacing between the nanostructures and the growing direction of the nanostructure depending on the characteristics of the sample to be measured.

The spacing between the nanostructures is adjusted by adjusting the temperature when the nanostructure is grown. The growing direction of the nanostructure may be adjusted through zinc-based solution surface treatment.

The substrate used in the inventive concept includes at least one of silicon, glass, PET, and an OHP film, and the reason why the substrate is used is to perform patterning to control the diffusion direction of a liquid sample.

Since the surface-enhanced Raman spectroscopy substrate according to the inventive concept is identically applied as described with reference to FIGS. 1 to 8, the duplication thereof will be omitted to avoid redundancy.

Although an embodiment of the inventive concept are described with reference to the accompanying drawings, it will be understood by those skilled in the art to which the inventive concept pertains that the inventive concept can be carried out in other detailed forms without changing the scope or the essential features of the claimed invention. Therefore, the embodiments described above are provided by way of example in all aspects, and should be construed not to be restrictive. The scope of the present invention is solely restricted and defined by the appended claims.

## Claims

1. A method for manufacturing a nanostructure-based substrate (10) for surface-enhanced Raman spectroscopy, the method comprising:
preparing (S110) a substrate (11);
performing a selective etching process after performing a lithography process for the substrate (11) by utilizing a polymer film having a specific pattern which is printed on the substrate (11) as a mask
depositing (S130) a zinc oxide, ZnO, seed layer on the substrate (11), wherein the depositing includes: depositing the ZnO seed layer in a region, which is selectively etched, of the substrate (11);
growing (S150) ZnO nanostructures (12) through a synthesis manner of applying a zinc, Zn, solution to the seed layer; and
coating (S170) the grown ZnO nanostructures with a metal (13),
wherein the growing (S150) includes:
depending on a characteristic of a sample to be measured, adjusting at least one of spacing between the ZnO nanostructures (12) and a growing direction of the ZnO nanostructures (12) by using at least one of a temperature adjusting manner and a Zn-based solution surface treatment manner,
wherein the spacing between the ZnO nanostructures (12) grown is adjusted as the temperature is adjusted, when the temperature adjusting manner is used, and
wherein the growing direction of the ZnO nanostructures (12) is adjusted, when the Zn-based solution surface treatment manner is used.

2. The method of claim 1, wherein the substrate (11) includes at least one of silicon, glass, PET, and an OHP film,

3. The method of claim 1, wherein the ZnO nanostructures (12) are grown to be different in at least one of the spacing between the ZnO nanostructures (12) and the growing direction of the ZnO nanostructures (12) inside one substrate (11).

4. The method of claim 1, wherein the substrate (11) includes a printing film, and
wherein the preparing (S110) includes:
forming a specific pattern by printing at least one of wax and a hydrophobic material on the substrate (11).

5. The method of claim 1, wherein the specific pattern is formed to control a diffusion direction of a liquid sample from a sample inlet (20) to the surface-enhanced Raman spectroscopy substrate (10).

6. A method for manufacturing a multi-sample measurement chip, comprising:
manufacturing at least two e-surface-enhanced Raman spectroscopy
substrates (10) according to any one of the claims 1 to 5,
combining (S190) and disposing at least two surface-enhanced Raman spectroscopy substrates (10); and
manufacturing (S210) a multi-sample measurement chip including the at least two surface-enhanced Raman spectroscopy substrates (10) and sample inlets (20), wherein a sample inlet
(20) of each surface-enhanced Raman spectroscopy substrate (10) is at a preset distance or more from the surface-enhanced Raman spectroscopy substrate (10), and is disposed to be formed to be in a preset size or more, wherein a preset slope is formed from the sample inlet (20) to the surface-enhanced Raman spectroscopy substrate (10).

7. The method of claim 6, further comprising:
moving a liquid sample from the sample inlet (20) to the surface-enhancedRaman spectroscopy substrate (10) in the multi-sample measurement
and
wherein the liquid sample is moved along the slope or through injection of a syringe or a syringe pump.

8. A nanostructure-based substrate (10) for surface-enhanced Raman spectroscopy manufactured by any of the method claims 1 to 5, comprising:
a substrate (11);
a zinc oxide, ZnO, seed layer which is deposited on the substrate (11);
ZnO nanostructures (12) grown on the ZnO seed layer; and
a metal (13) coated on the ZnO nanostructures (12).

## Patentansprüche

1. Verfahren zur Herstellung eines nanostrukturbasierten Substrats (10) für die oberflächenverstärkte Raman-Spektroskopie, wobei das Verfahren umfasst:
das Vorbereiten (S110) eines Substrats (11);
das Durchführen eines selektiven Ätzverfahrens nach dem Durchführen eines Lithographieverfahrens für das Substrat (11) unter Verwendung eines Polymerfilms mit einem spezifischen Muster, das als Maske auf das Substrat (11) gedruckt wird,
das Abscheiden (S130) einer Keimschicht aus Zinkoxid, ZnO, auf dem Substrat (11), wobei das Abscheiden Folgendes umfasst: Abscheiden der ZnO-Keimschicht in einem Bereich des Substrats (11), der selektiv geätzt ist;
das Wachsenlassen (S150) von ZnO-Nanostrukturen (12) durch eine Synthesemethode, bei der eine Lösung von Zink, Zn, auf die Keimschicht aufgetragen wird; und
das Beschichten (S170) der gewachsenen ZnO-Nanostrukturen mit einem Metall (13),
wobei das Wachsenlassen (S150) Folgendes umfasst:
in Abhängigkeit von einem Merkmal einer zu messenden Probe, Einstellen des Abstands zwischen den ZnO-Nanostrukturen (12) und/oder der Wachstumsrichtung der ZnO-Nanostrukturen (12) durch Verwendung einer Temperatureinstellmethode und/oder einer Methode der Oberflächenbehandlung mit einer Zn-basierten Lösung,
wobei der Abstand zwischen den gewachsenen ZnO-Nanostrukturen (12) durch die Einstellung der Temperatur eingestellt wird, wenn die Temperatureinstellmethode verwendet wird, und
wobei die Wachstumsrichtung der ZnO-Nanostrukturen (12) eingestellt wird, wenn die Methode der Oberflächenbehandlung mit einer Zn-basierten Lösung verwendet wird.

2. Verfahren gemäß Anspruch 1, wobei das Substrat (11) wenigstens eines aus Silicium, Glas, PET und einer OHP-Folie umfasst.

3. Verfahren gemäß Anspruch 1, wobei die ZnO-Nanostrukturen (12) so wachsen gelassen werden, dass sie sich innerhalb eines Substrats (11) hinsichtlich des Abstands zwischen den ZnO-Nanostrukturen (12) und/oder der Wachstumsrichtung der ZnO-Nanostrukturen (12) unterscheiden.

4. Verfahren gemäß Anspruch 1, wobei das Substrat (11) eine Druckfolie umfasst und
wobei das Vorbereiten (S110) Folgendes umfasst:
das Ausbilden eines spezifischen Musters durch Drucken von Wachs und/oder einem hydrophoben Material auf das Substrat (11).

5. Verfahren gemäß Anspruch 1, wobei das spezifische Muster so ausgebildet wird, dass die Diffusionsrichtung einer flüssigen Probe von einem Probeneinlass (20) aus zu dem Substrat für die oberflächenverstärkte Raman-Spektroskopie (10) gesteuert wird.

6. Verfahren zur Fertigung eines Mehrproben-Messchips, umfassend:
das Fertigen von wenigstens zwei Substraten für die oberflächenverstärkte Raman-Spektroskopie (10) gemäß einem der Ansprüche 1 bis 5,
das Kombinieren (S190) und Anordnen von wenigstens zwei Substraten für die oberflächenverstärkte Raman-Spektroskopie (10); und
das Fertigen (S210) eines Mehrproben-Messchips, der die wenigstens zwei Substrate für die oberflächenverstärkte Raman-Spektroskopie (10) und Probeneinlässe (20) umfasst, wobei sich ein Probeneinlass (20) jedes Substrats für die oberflächenverstärkte Raman-Spektroskopie (10) in einem vorher festgelegten Abstand von dem Substrat für die oberflächenverstärkte Raman-Spektroskopie (10) oder weiter davon weg befindet und so angeordnet wird, dass er in einer vorher festgelegten Größe oder größer ausgebildet wird, wobei eine vorher festgelegte Neigung von dem Probeneinlass (20) aus zu dem Substrat für die oberflächenverstärkte Raman-Spektroskopie (10) ausgebildet wird.

7. Verfahren gemäß Anspruch 6, weiterhin umfassend:
das Bewegen einer flüssigen Probe von dem Probeneinlass (20) aus zu dem Substrat für die oberflächenverstärkte Raman-Spektroskopie (10) in dem Mehrproben-Messchip,
wobei die flüssige Probe entlang der Neigung oder durch Injektion mittels einer Spritze oder einer Spritzenpumpe bewegt wird.

8. Nanostrukturbasiertes Substrat (10) für die oberflächenverstärkte Raman-Spektroskopie, gefertigt nach einem der Verfahren der Ansprüche 1 bis 5, umfassend:
ein Substrat (11);
eine Keimschicht aus Zinkoxid, ZnO, die auf dem Substrat (11) abgeschieden ist,
ZnO-Nanostrukturen (12), die auf der ZnO-Keimschicht gewachsen sind; und
ein Metall (13), mit dem die ZnO-Nanostrukturen (12) beschichtet sind.

## Revendications

1. Procédé pour fabriquer un substrat à base de nanostructures (10) pour la spectroscopie Raman exaltée par effet de surface, ledit procédé comprenant les étapes consistant à :
préparer (S110) un substrat (11) ;
effectuer un procédé de gravure sélective après avoir effectué un procédé de lithographie pour le substrat (11), en utilisant un film polymère ayant un motif spécifique qui est imprimé sur le substrat (11) comme masque,
déposer (S130) une couche d'amorçage d'oxyde de zinc, ZnO, sur le substrat (11), dans lequel l'étape consistant à déposer comprend : le dépôt d'une couche d'amorçage de ZnO dans une région du substrat (11) qui est gravée sélectivement ;
faire croître (S150) des nanostructures de ZnO (12) par une méthode de synthèse consistant à appliquer une solution de zinc, Zn, sur la couche d'amorçage ; et
revêtir (S170) d'un métal (13) les nanostructures de ZnO formées par croissance,
dans lequel l'étape consistant à faire croître (S150) comprend :
en fonction d'une caractéristique de l'échantillon à mesurer, l'ajustement d'au moins l'un parmi l'espacement entre les nanostructures de ZnO (12) et une direction de croissance des nanostructures de ZnO (12) en utilisant au moins l'une des méthodes suivantes : une méthode d'ajustement de la température et une méthode de traitement de surface avec une solution à base de Zn,
dans lequel l'espacement entre les nanostructures de ZnO (12) formées par croissance est ajusté par ajustement de la température, lorsque la méthode d'ajustement de la température est utilisée, et
dans lequel la direction de croissance des nanostructures de ZnO (12) est ajustée, lorsque la méthode de traitement de surface avec une solution à base de Zn est utilisée.

2. Procédé selon la revendication 1, dans lequel le substrat (11) comprend au moins l'un parmi le silicium, le verre, le PET et un film pour rétroprojecteur (OHP).

3. Procédé selon la revendication 1, dans lequel les nanostructures de ZnO (12) sont formées par croissance de manière à différer, au sein d'un même substrat (11), selon au moins l'un parmi l'espacement entre les nanostructures de ZnO (12) et la direction de croissance des nanostructures de ZnO (12).

4. Procédé selon la revendication 1, dans lequel le substrat (11) comprend un film d'impression, et
dans lequel l'étape consistant à préparer (S110) comprend :
la formation d'un motif spécifique en imprimant de la cire et/ou un matériau hydrophobe sur le substrat (11).

5. Procédé selon la revendication 1, dans lequel le motif spécifique est formé pour piloter la direction de diffusion d'un échantillon liquide depuis une entrée d'échantillon (20) jusqu'au substrat (10) pour la spectroscopie Raman exaltée par effet de surface.

6. Procédé pour fabriquer une puce de mesure multi-échantillon, comprenant les étapes consistant à :
fabriquer au moins deux substrats (10) pour la spectroscopie Raman exaltée par effet de surface selon l'une quelconque des revendications 1 à 5,
combiner (S190) et disposer au moins deux substrats (10) pour la spectroscopie Raman exaltée par effet de surface ; et
fabriquer (S210) une puce de mesure multi-échantillon incluant les au moins deux substrats (10) pour la spectroscopie Raman exaltée par effet de surface et des entrées d'échantillon (20), dans lequel une entrée d'échantillon (20) de chaque substrat (10) pour la spectroscopie Raman exaltée par effet de surface est espacée du substrat (10) pour la spectroscopie Raman exaltée par effet de surface d'une distance au moins égale à une distance prédéfinie, et est agencée de manière à présenter une taille au moins égale à une taille prédéfinie, dans lequel une pente prédéfinie est formée à partir de l'entrée d'échantillon (20) jusqu'au substrat (10) pour la spectroscopie Raman exaltée par effet de surface.

7. Procédé selon la revendication 6, comprenant en outre l'étape consistant à :
déplacer un échantillon liquide de l'entrée d'échantillon (20) vers le substrat (10) pour la spectroscopie Raman exaltée par effet de surface dans la puce de mesure multi-échantillon,
et
dans lequel ledit échantillon liquide est déplacé le long de la pente ou par injection à l'aide d'une seringue ou d'une pompe à seringue.

8. Substrat à base de nanostructures (10) pour la spectroscopie Raman exaltée par effet de surface fabriqué selon l'une quelconque des revendications de procédé 1 à 5, comprenant :
un substrat (11) ;
une couche d'amorçage d'oxyde de zinc, ZnO, qui est déposée sur le substrat (11),
des nanostructures de ZnO (12) formées par croissance sur la couche d'amorçage de ZnO ; et
un métal (13) dont les nanostructures de ZnO (12) sont revêtues.
